# EUROPEAN PATENT SPECIFICATION

(11) **EP 1 653 529 B1**
(45) Date of publication and mention of the grant of the patent: **21.11.2007**
(21) Application number: 05109233.6
(22) Date of filing: 05.10.2005
(51) Int. Cl.: H01L 51/52

(54) **Organic electroluminescent device and method of manufacturing the same**
Organische elektrolumineszierende Vorrichtung und deren Herstellungsmethode
Dispositif électroluminescent organique et sa méthode de fabrication

(30) Priority: 11.10.2004 KR 2004081114; 04.08.2005 KR 2005071502
(43) Date of publication of application: 03.05.2006
(73) Proprietor: Samsung SDI Co., Ltd., Suwon-si Gyeonggi-do (KR)
(72) Inventor: Kim, Tae-Shick Samsung SDI Co., Ltd., Gyeonggi-do (KR); Jeong, Hye-In Samsung SDI Co., Ltd., Gyeonggi-do (KR); Koo, Young-Mo Samsung SDI Co., Ltd., Gyeonggi-do (KR); Song, Ok-Keun Samsung SDI Co., Ltd., Gyeonggi-do (KR); Lee, Jun-Yeob Legal &IP Team Samsung SDI Co., Ltd., Gyeonggi-do (KR); Chun, Min-Seung Samsung SDI Co., Ltd., Gyeonggi-do (KR); Kim, Mi-Kyung Samsung SDI Co., Ltd., Gyeonggi-do (KR)
(74) Representative: Hengelhaupt, Jürgen

(56) References cited:
- EP-A- 1 339 264
- WO-A-20/04029176
- US-A1- 2004 214 041
- US-B1- 6 670 054
- KATO K ET AL: "Organic light - emitting diodes with a nanostructured fullerene layer at the interface between Alq3 and TPD layers" JAPANESE JOURNAL OF APPLIED PHYSICS, PHYSICAL SOCIETY OF JAPAN, TOKYO, JP, vol. 42, no. 4b, April 2003 (2003-04), pages 2526-2529, XP002296275 ISSN: 0021-4922
- KIM J-Y ET AL: "Electrical and optical studies of organic light emitting devices using SWCNTs-polymer nanocomposites" OPTICAL MATERIALS, ELSEVIER SCIENCE PUBLISHERS B.V. AMSTERDAM, NL, vol. 21, no. 1-3, January 2003 (2003-01), pages 147-151, XP004395412 ISSN: 0925-3467
- FOURNET P ET AL: "A carbon nanotube composite as an electron-transport layer in organic light-emitting diodes" CONFERENCE ON LASERS AND ELECTRO-OPTICS. (CLEO 2001). TECHNICAL DIGEST. POSTCONFERENCE EDITION. BALTIMORE, MD, MAY 6-11, 2001, TRENDS IN OPTICS AND PHOTONICS. (TOPS), US, WASHINGTON, WA : OSA, US, vol. VOL. 56, 6 May 2001 (2001-05-06), pages 34-35, XP010559526 ISBN: 1-55752-662-1
- FOURNET P ET AL: "Enhanced brightness in organic light-emitting diodes using a carbon nanotube composite as an electron-transport layer" JOURNAL OF APPLIED PHYSICS, AMERICAN INSTITUTE OF PHYSICS. NEW YORK, US, vol. 90, no. 2, 15 July 2001 (2001-07-15), pages 969-975, XP012053868 ISSN: 0021-8979

## Description

### BACKGROUND OF THE INVENTION

### 1. Field of the Invention

The present invention relates to an organic electroluminescent device and a method of manufacturing the same, and more particularly, to an organic electroluminescent device having a long lifetime and low power consumption and a method of manufacturing the same.

### 2. Description of the Related Art

Organic EL devices are self-emissive. That is, when a voltage is applied to an organic layer interposed between an anode and a cathode, electrons and holes combine in the organic layer, thus emitting light. Organic EL devices can be used to form an information display device with high resolution, a quick response time, a wide viewing angle, lightweight, and thinness. Organic EL devices have an expanding range of applications, including mobile phones, high-end information display devices, and the like.

Organic EL devices have been developed to the extent that they now compete with thin film transistor liquid crystalline displays (TFT-LCDs) in industrial markets as well as academic arenas. However, organic EL devices have many problems preventing quality development, mass production such as low efficiency, short lifetimes, and high power consumption. These problems must be solved.
In the article 'organic light-emitting diodes with a nanostructured fullerene layer at the interface between Alq3 and TPD layers' of Kato K. et al., Japanese Journal of Applied Physics, Vol. 42, pages 2526 to 2529, an OLED having a buffer layer of fullerene C60 deposited between the hole-transport layer (TPD) and the emission layer (Alq₃) is disclosed. Experimental characteristics of luminescence and current density depending on a thickness of the buffer layer are provided.
US 6,670,054 B1 discloses an OLED comprising among others a buffer layer deposited between the anode and a hole transporting layer or hole injection-assistant layer. The buffer layer may include materials with conductive properties like amorphous graphite or carbon.

### SUMMARY OF THE INVENTION

The present invention provides an organic electroluminescent (EL) device having a low driving voltage regardless of the type of an emission material, such that power consumption decreases and lifetime increases.

The present invention also provides a method of manufacturing the organic EL device, the method including forming a buffer layer formed of a carbon-based compound. In this case, the efficiency and lifetime of the organic EL device is more improved by controlling the thickness of the buffer layer.

According to an aspect of the present invention, there is provided an organic EL device comprising
an emission layer interposed between a first electrode and a second electrode; and
a buffer layer, which is formed of a carbon-based compound between the emission layer and the first electrode, wherein the carbon-based compound is a fullerene. The organic EL device further comprises
   (i) a hole injection layer between the first electrode and the emission layer, wherein the buffer layer is formed between the first electrode and the hole injection layer; and/or
   (ii) a hole transport layer between the first electrode and the emission layer, wherein the buffer layer is formed between the first electrode and the hole transport layer.
Preferably, the buffer layer is formed to a thickness of 0.1 nm - 100 nm between the emission layer and the first electrode.

According to another aspect of the present invention, there is provided a method of manufacturing the above-mentioned organic EL device. The method comprising forming a buffer layer to a thickness of 0.1 nm to 100 nm between the emission layer and the first electrode.

The organic EL device may further include a hole transport layer formed between the hole injection layer and the emission layer, and a buffer layer formed of the carbon-based compound formed between the hole injection layer and the hole transport layer. In addition, when the buffer layer formed of the carbon-based compound is formed between the first electrode and the hole injection layer, the hole injection layer may be doped with the carbon-based compound.

At least one of the hole injection layer and the hole transport layer may be formed of the carbon-based compound. An amount of the carbon-based compound may be in the range of 0.005 to 99.95 parts by weight based on 100 parts by weight of each layer.

The organic EL device may further includes at least one layer selected from the group consisting of a hole blocking layer, an electron transport layer, and an electron injection layer between the emission layer and the second electrode.

According to still another aspect of the present invention, there is provided an organic EL device includes: a substrate; a first electrode formed on the substrate; a hole transport layer formed on the first electrode; an emission layer formed on the hole transport layer; and a second electrode formed on the emission layer, wherein a buffer layer formed of a carbon-based compound is interposed between the first electrode and the hole transport layer.

The organic EL device may further includes at least one layer selected from the group consisting of a hole blocking layer, an electron injection layer, and an electron transport layer between the emission layer and the second electrode.

According to another aspect of the present invention, there is provided an organic EL device includes: a substrate; a first electrode formed on the substrate; a hole injection layer formed on the first electrode; a hole transport layer formed on the hole injection layer; an emission layer formed on the hole transport layer; and a second electrode formed on the emission layer, and a buffer layer formed of a carbon-based compound interposed between the hole injection layer and the hole transport layer.

The organic EL device may further include at least one layer of an electron injection layer and a hole-blocking layer between the electron transport layer and the second electrode.

### BRIEF DESCRIPTION OF THE DRAWINGS

The above and other features and advantages of the present invention will become more apparent by describing in detail exemplary embodiments thereof with reference to the attached drawings in which:

FIGS. 1 through 5 are sectional views of organic EL devices according to embodiments of the present invention; and

FIG. 6 shows a structure of C60 fullerene that is used in the present invention.

### DETAILED DESCRIPTION OF THE INVENTION

An organic electroluminescent (EL) device according to an embodiment of the present invention includes an emission layer interposed between a first electrode and a second electrode, and a buffer layer formed of a carbon-based compound is interposed between the first electrode and the emission layer.

The organic EL device may further include a hole injection layer between the first electrode (anode) and the emission layer, and in this structure, the buffer layer can be formed between the first electrode and the hole injection layer, between the hole injection layer and the emission layer, or both between the first electrode and the hole injection layer and between the hole injection layer and the emission layer.

In addition, the organic EL device may further include a hole transport layer interposed between the first electrode and the emission layer, and in this structure, the buffer layer can be formed between the first electrode and the hole transport layer, between the hole transport layer and the emission layer, or both between the first electrode and the hole transport layer and between the hole transport layer and the emission layer.

In addition, the organic EL device may further include the hole injection layer and the hole transport layer sequentially formed between the first electrode and the emission layer, and in this structure, the buffer layer can be formed between at least one of the combinations of the first electrode and the hole injection layer, the hole injection layer and the hole transport layer, and the hole transport layer and the emission layer.

As described above, by including a buffer layer formed of the carbon-based compound between the first electrode and the emission layer, the morphology of the organic EL device formed in a thin film does not change, the color coordinate of the organic EL device does not change, and at the same time, the intersurface energy band gap between the ITO electrode used as the first electrode and the hole injection layer is changed such that holes can be more easily injected to the hole injection layer from the ITO electrode, thus decreasing the driving voltage. In addition, the buffer layer that is stably formed between the ITO electrode as the first electrode and the hole injection layer contributes to a long lifetime of the organic EL device.

The thickness of the buffer layer may be in the range of 0.1 to 100 nm, preferably, 1 to 10 nm, and more preferably, 5-8 nm. When the thickness of the buffer layer is less than 0.1 nm, the characteristics of the organic electroluminescent device is not improved. When the thickness of the buffer layer is greater than 100 nm, the characteristics of the organic electroluminescent device, such as lifetime, contrast, or the like, are improved, but the width of a driving voltage drop is saturated or the width of voltage gain is reduced.

As described above, the organic EL device according to an embodiment of the present invention includes a buffer layer formed of a carbon-based compound, such as fullerene, interposed between the first electrode and the hole injection layer, between the hole injection layer and the hole transport layer, and/or between the first electrode and the hole transport layer. Alternatively, the buffer layer formed of the carbon-based compound can be formed between the first electrode and the hole injection layer, between the first electrode and the hole transport layer, and/or between the hole injection layer and the hole transport layer. In this case, the hole injection layer and/or the hole transport layer are doped with the carbon-based compound. Alternatively, an electron transport layer is doped with the carbon-based compound. Alternatively, a buffer layer doped with the carbon-based compound is formed between the first electrode and the hole injection layer and/or between the first electrode and the hole transport layer, and an electron transport layer is doped with the carbon-based compound.

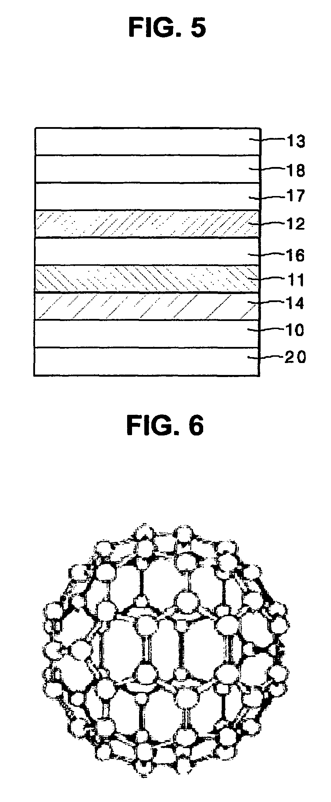

The carbon-based compound is not limited, but may be a carbon-based complex containing a metal, that is, a carbon allotrope containing 60 to 500 carbons and a metal. The carbon-based compound may be at least one compound selected from fullerene, a complex compound of fullerene containing a metal, carbon nano tube, carbon fiber, carbon black, graphite, carbine, MgC60, CaC60, and SrC60. Preferably, the carbon-based compound is fullerene having the structure illustrated in FIG. 6.

Fullerene (also called buckyballs) is formed by irradiating graphite with a strong laser in a vacuum such that carbon atoms are separated from the surface of the graphite and the separated carbon atoms are combined to form a new structure. Examples of fullerene include C60 formed of 60 carbon atoms, C70, C76, C84, and the like.

Meanwhile, the buffer layer between ITO electrode used as the anode and the hole injection layer includes the carbon-based compound, the hole injection layer and/or the hole transport layer, or the electron transport layer can be doped with the carbon-based compound. The carbon-based compound can be doped to an amount in the range of 0.005 to 99.95 parts by weight on 100 parts by weight of the hole injection layer, the hole transport layer, or the electron transport layer. When the amount of the carbon-based compound is outside this range, an improvement of characteristics of the organic EL device is negligible.

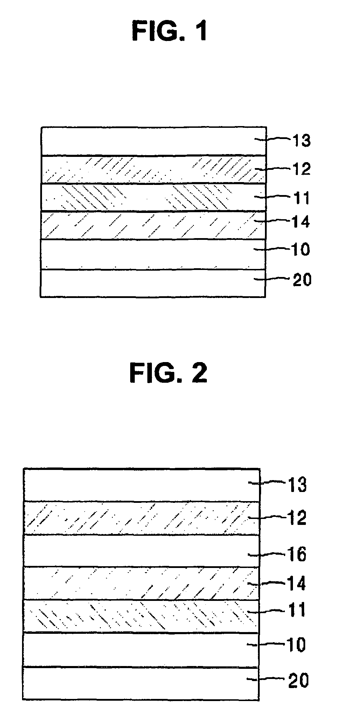

FIGS. 1 through 5 are sectional views of organic EL devices according to embodiments of the present invention.

Referring to FIG. 1, a first electrode 10 is deposited on a substrate 20, a hole injection layer 11 is deposited on the first electrode 10, and an emission layer 12 and a second electrode 13 are sequentially deposited on the hole injection layer 11. A buffer layer 14 formed of a carbon-based compound is interposed between the first electrode 10 and the hole injection layer 11. The hole injection layer 11 can be doped with the carbon-based compound.

Referring to FIG. 2, the organic EL device which does not form part of the claimed invention includes a first electrode 10 deposited on a substrate 20; a hole injection layer 11 and a hole transport layer 16 sequentially deposited on the first electrode 10; and an emission layer 12 and a second electrode 13 sequentially deposited on the hole transport layer 16; and a buffer layer 14 formed of a carbon-based compound interposed between the hole injection layer 11 and the hole transport layer 16.

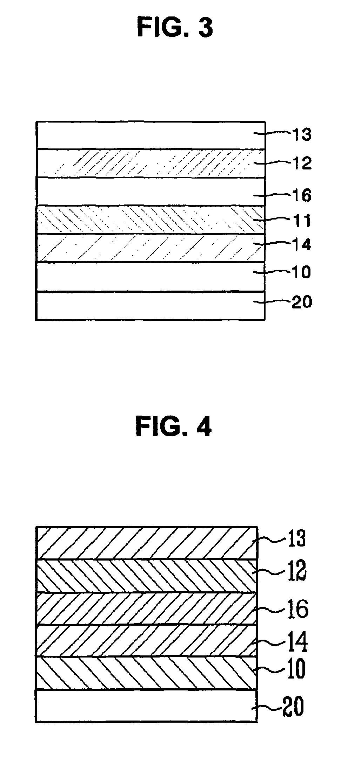

The organic EL device illustrated in FIG. 3 has the same structure as the organic EL device illustrated in FIG. 1, except that the hole transport layer 16 is interposed between the hole injection layer 11 and the emission layer 12.

The organic EL device illustrated in FIG. 4 includes a first electrode 10 deposited on a substrate 20, a buffer layer 14 formed of a carbon-based compound and a hole transport layer 16 sequentially deposited on the first electrode 10, and an emission layer 12 and a second electrode 13 sequentially deposited on the hole transport layer 16.

The organic EL device which does not form part of the claimed invention illustrated in FIG. 5 has the same structure as the organic El device illustrated in FIG. 3, except that an electron transport layer 17 and an electron injection layer 18 are sequentially formed between the emission layer 12 and the second electrode 13. The hole injection layer 11 and/or the hole transport layer 16 or the electron transport layer 17 can be doped with a carbon-based compound.

The organic EL devices according to embodiments of the present invention may further include a hole blocking layer, or an intermediate layer to improve interface characteristics between layers, which are not shown in the drawings.

A method of manufacturing an organic EL device according to an embodiment of the present invention illustrated in FIG. 5 will now be described.

A patterned first electrode 10 is deposited on a substrate 20. The substrate is a substrate used in a conventional organic EL device, a glass substrate or a transparent plastic substrate, which is transparent and waterproof, has a smooth surface, and can be easily treated. The substrate may have a thickness of 0.3 to 1.1 mm.

The first electrode 10 may be formed of a conducting metal or an oxide thereof such that holes can be easily injected onto the first electrode 10. The conducting metal or the oxide thereof may be Indium Tin Oxide (ITO), Indium Zinc Oxide (IZO), Ni, Pt, Au, lr, or the like.

The resultant substrate is cleaned with an organic solvent, such as isopropanol (IPA) and acetone, and then is subject to an UV/ozone treatment.

A buffer layer 14 is formed on the first electrode 10 of the cleaned substrate using any method that is conventional in the art, for example, a deposition method. The carbon-based compound that is used to form the buffer layer 12 may include at least one compound selected from the group consisting of fullerene, a fullerene-based complex compound containing a metal, a carbon nano tube, a carbon fiber, a carbon black, a graphite, carbine, MgC60, CaC60, and SrC60. For example, the carbon-based compound that is used to form the buffer layer 12 may be fullerene.

In addition, the buffer layer 12 may be formed to a thickness of 1 nm to 10 nm at the deposition rate of 0.01 to 0.2 nm/s under a vacuum condition. In particular, when the buffer layer 12 is formed to a thickness of 1 to 5 nm, the deposition rate may be in the range of 0.01 to 0.05 nm/s. When the buffer layer 12 is formed to a thickness of 5 to 10 nm, the deposition rate may be in the range of 0.05 to 0.2 nm/s. The formation of the buffer layer at such deposition rate range affects efficiency and lifetime of the organic EL device, which is supposed to occur due to a small change of the morphology. Such will be confirmed in Examples and Comparative Examples later.

Then, a hole injection material is vacuum thermal deposited or spin coated on the buffer layer 14 to form a hole injection layer 11. The hole injection layer 11 decreases a contact resistance between the first electrode 10 and an emission layer and increases a hole transporting ability from the first electrode 10 to the emission layer. Therefore, a driving voltage of the organic EL device decreases, and the lifetime of the organic EL device improves.

The hole injection layer 11 may have a thickness of 30 to 150 nm.
When the thickness of the hole injection layer 11 is less than 30 nm, the lifetime and reliability of the organic EL device is reduced, and a resolution short may occur in a passive matrix type organic EL device, which is undesirable. When the thickness of the hole injection layer 11 is greater than 150 nm, a driving voltage of the device increases, which is undesirable.

The hole injection layer 11 may be formed of copper phthalocyanine (CuPc); a starburst-type amine, such as TCTA, m-MTDATA, IDE406 (obtained from ldemitz.Co.); or the like. However, the hole injection layer 11 can be formed of other materials.

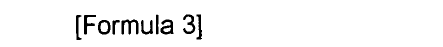

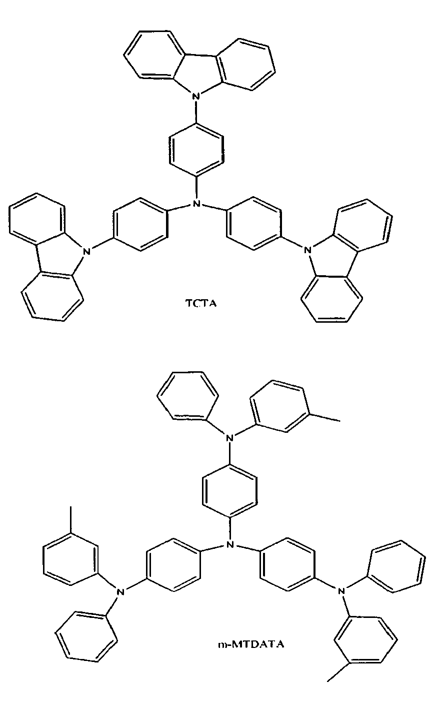

A hole transport material is vacuum thermally deposited or spin coated on the hole injection layer 11 that is formed according to the above process, to form a hole transport layer 16. The hole transporting material may be
N,N'-bis(3-methylphenyl)-N,N'-diphenyl-[1,1-biphenyl]-4,4'-diamine(TPD);
N,N'-di(naphthalene -1-yl)-N,N'-diphenylbenzidine (α -NPD); IDE320(obtained from Idmitz Co.); or the like, but is not limited thereto. The thickness of the hole transport layer 11 may be in the range of 10 to 40 nm. When the thickness of the hole transport layer 11 is less than 10 nm, a hole transporting ability decreases due to the small thickness, which is undesirable. When the thickness of the hole transport layer 11 is greater than 40 nm, the driving voltage of the device increases, which is undesirable.

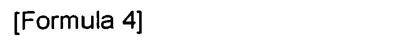

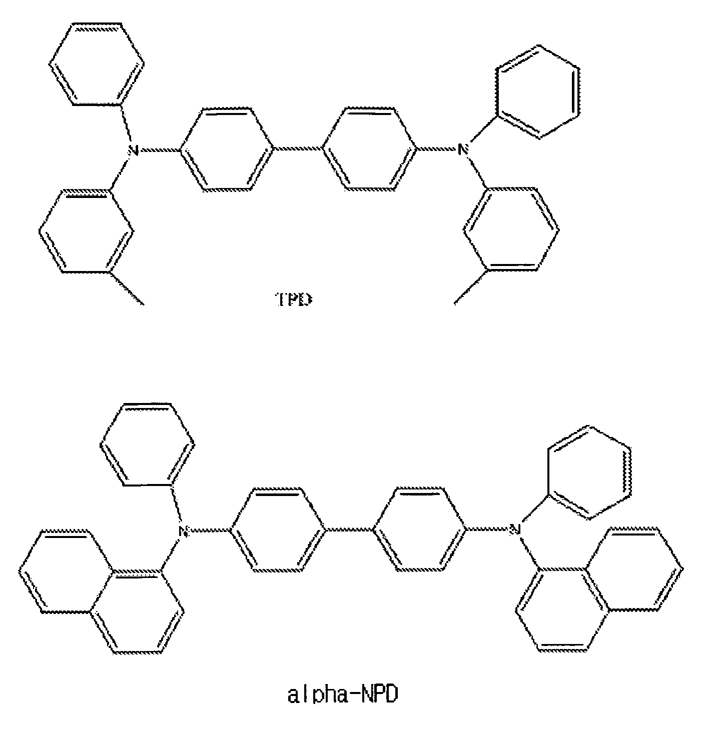

Subsequently, an emission layer 12 is formed on the hole transport layer 16 by vacuum thermal deposition or spin coating.

The emission layer 12 may be formed of a complex compound of AI, such as Alq3(tris(8-quinolinolato)-aluminium), BAlq, Salq, and Almq3; a complex compound of Ga, such as Gaq'₂OPiv, Gaq'₂OAc, and 2(Gaq'₂); a fluorene; polyparaphenylene vinylene or a derivative thereof; a biphenyl derivative; a spiro polyfluorene-based polymer; or the like.

| | | |
|---|---|---|
| 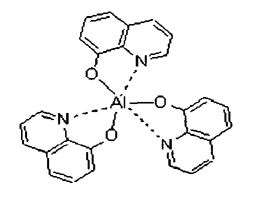 | 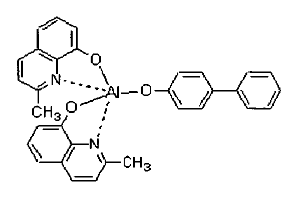 | |
| Alq3 | BAlq | |
| 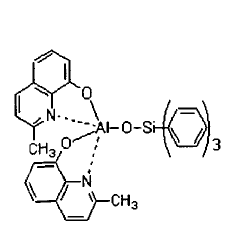 | 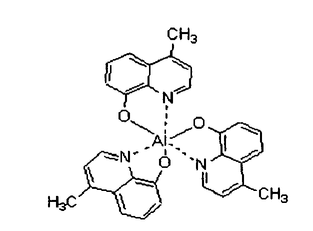 | |
| SAlq | Almq3 | |
| 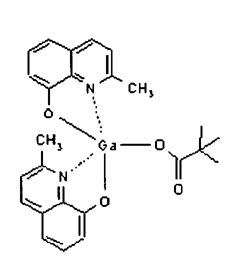 | 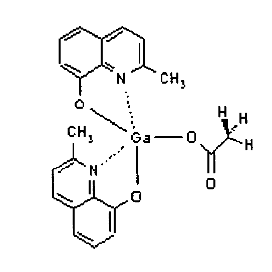 | 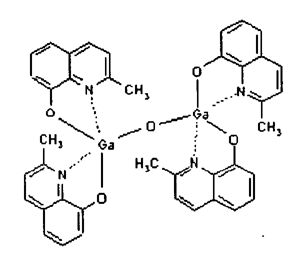 |
| Gaq'₂OPiv | Gaq'₂OAc, | 2(Gaq'2) |

The emission layer 12 may have a thickness of 15 to 60 nm, preferably, 30 to 50 nm. As the emission layer 12 becomes thicker, the driving voltage of the device increases. Therefore, the emission layer 12 with a thickness of greater than 60 nm cannot be used in the organic EL device.

Optionally, a hole-blocking layer (not shown in FIG. 5) may further be formed on the emission layer 12. The hole blocking layer is formed by vacuum-depositing a hole blocking material on the emission layer 12, or by spin-coating the emission layer 12 with the hole blocking material. The hole blocking material may have an electron transporting ability, and an ionization potential greater than the ionisation potential of the emission material. The hole blocking material may be bis (2-methyl-8-quinolato)-(p-phenylphenolato)-aluminum (Balq), bathocuproine(BCP), tris(N-arylbenzimidazole)(TPBI), or the like, but is not limited thereto. The thickness of the hole blocking layer may be in the range of 3 nm to 7 nm. When the thickness of the hole blocking layer is less than 3 nm, a hole blocking ability is weak, which is undesirable. When the thickness of the hole-blocking layer is greater than 7 nm, the driving voltage of the device increases, which is undesirable.

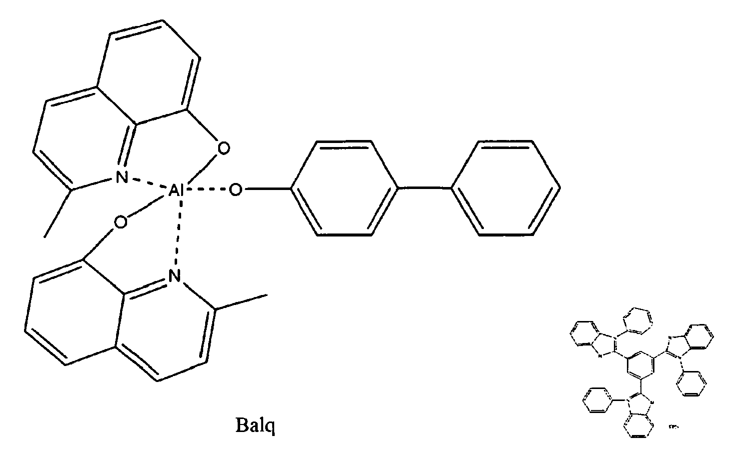

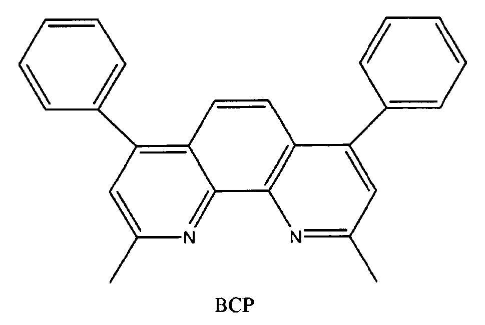

An electron transport layer 17 is formed by vacuum-depositing an electron transporting material on the hole-blocking layer, or by spin-coating the hole-blocking layer with the electron transporting material. The electron transporting material may be Alq3, but is not limited thereto.

According to the present embodiment, the buffer layer 14 formed of the carbon-based compound can be interposed between the anode 10 and the hole injection layer 11. In addition, the hole injection layer 11 and/or the hole transport layer 16 or the electron transport layer 17 can be doped with the carbon-based compound.

That is, the carbon-based compound is deposited between the anode 10 and the hole injection layer 11 to form the buffer layer 14; and the hole injection layer 11 and/or the hole transport layer 16 or the electron transport layer 17 are formed by vacuum-thermal co-depositing the hole injection material, the hole transporting material, or the electron transporting material with the carbon-based compound. The amount of the carbon-based compound is in the range of 0.005 to 99.95 parts by weight based on 100 parts by weight of the hole injection layer, the hole transport layer, or the electron transport layer.

The thickness of the electron transport layer 17 may be in the range of 15 nm to 60 nm. When the thickness of the electron transport layer 17 is less than 15 nm, an electron transporting ability decreases, which is undesirable. When the thickness of the electron transport layer 17 is greater than 60 nm, the driving voltage increases, which is undesirable.

In addition, an electron injection layer 18 may be optionally formed on the electron transport layer 17. The electron injection layer 18 may be formed of LiF, NaCl, CsF, Li₂O, BaO, Liq, or the like. The thickness of the electron injection layer 18 may be in the range of 0.5 nm to 2 nm. When the thickness of the electron injection layer 18 is less than 0.5 nm, an electron injecting ability decreases, which is undesirable. When the thickness of the electron injection layer 18 is greater than 2 nm, the driving voltage increases, which is undesirable.

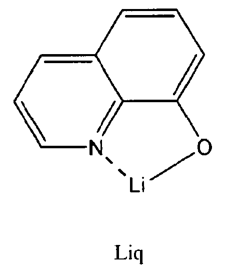

Subsequently, a cathode metal is vacuum-thermal deposited on the electron injection layer 18 to form a cathode, which is a second electrode 13. As a result, the organic EL device is completely formed.

The cathode metal may be Li, Mg, Al, Al-Li, Ca, Mg-In, Mg-Ag, or the like.

The organic EL device according to embodiments of the present invention includes an anode, a hole injection layer, a hole transport layer, an emission layer, an electron transport layer, an electron injection layer, a cathode, and when needed, one or two intermediate layers. In addition, the organic EL device may further include an electron-blocking layer.

The present invention will now be described in further detail with reference to the following examples. The following examples are for illustrative purposes only.

### Example 1

A 15Ω /cm²(120nm) glass substrate obtained from Corning Co was cut to a size 50 mm x 50 mm x 0.7 mm, cleaned using ultrasonic waves in isopropyl alcohol for 5 minutes, cleaned using ultrasonic waves in pure water for 5 minutes, and cleaned using UV and ozone for 30 minutes. The result was used as an anode. In the manufacturing process for an organic EL device, the cleaned ITO glass substrate was subjected to a plasma treatment at a pressure of 0.1 mtorr for 9 minutes.

Buckminster fullerene (C60) was thermally deposited on the substrate at a pressure of 10⁻⁶ torr at a deposition rate of 0.01 nm/s to form a buffer layer with a thickness of 3 nm. Then, IDE406 (obtained from ldemitz Co.) was vacuum-thermal deposited on the buffer layer to form a hole injection layer with a thickness of 70 nm. Subsequently, NPD was vacuum-thermal deposited on the hole injection layer to form a hole transport layer with a thickness of 15 nm.

Then, Alq3 doped with C545T was vacuum thermal deposited on the hole transport layer to form a green emission layer with a thickness of about 35 nm. Subsequently, Alg3 that is an electron transporting material was deposited on the emission layer to form an electron transport layer with a thickness of 25 nm.

LiF was vacuum-deposited on the electron transport layer to form a 1 nm-thick electron injection layer and Al was deposited on the electron injection layer to form an 80 nm-thick cathode, thereby forming a LiF/Al electrode. As a result, an organic EL device was manufactured.

### Example 2

A 15Ω /cm²(120 nm) glass substrate obtained from Corning Co was cut to a size 50 mm x 50 mm x 0.7 mm, cleaned using ultrasonic waves in isopropyl alcohol for 5 minutes, cleaned using ultrasonic waves in pure water for 5 minutes, and cleaned using UV and ozone for 30 minutes. The result was used as an anode. In the manufacturing process for an organic EL device, the cleaned ITO glass substrate was subjected to a plasma treatment at a pressure of 0.1 mtorr for 9 minutes.

Buckminster fullerene (C60) was thermally deposited on the substrate at a pressure of 10⁻⁶ torr at a deposition rate of 0.05 nm/s to form a buffer layer with a thickness of 3 nm. Then, NPD was vacuum-thermal deposited on the buffer layer to a thickness of 15 nm to form a hole transport layer.

Then, Alq3 doped with C545T was vacuum thermal deposited on the hole transport layer to form a green emission layer with a thickness of about 35 nm. Subsequently, Alg3 that is an electron transporting material was deposited on the emission layer to form an electron transport layer with a thickness of 25 nm.

LiF was vacuum-deposited on the electron transport layer to form a 1 nm-thick electron injection layer and Al was deposited on the electron injection layer to form an 80 nm-thick cathode, thereby forming a LiF/Al electrode. As a result, an organic EL device was manufactured.

### Example 3

An organic EL device was manufactured in the same manner as in Example 1, except that the buffer layer was deposited at a deposition rate of 0.1 nm/s to a thickness of 3 nm.

### Example 4

An organic EL device was manufactured in the same manner as in Example 2, except that the buffer layer was deposited at a deposition rate of 0.2 nm/s to a thickness of 3 nm.

### Example 5

An organic EL device was manufactured in the same manner as in Example 1, except that the buffer layer was deposited at a deposition rate of 0.01 nm/s to a thickness of 7 nm.

### Example 6

An organic EL device was manufactured in the same manner as in Example 2, except that the buffer layer was deposited at a deposition rate of 0.05 nm/s to a thickness of 7 nm.

### Example 7

An organic EL device was manufactured in the same manner as in Example 1, except that the buffer layer was deposited at a deposition rate of 0.1 nm/s to a thickness of 7 nm.

### Example 8

An organic EL device was manufactured in the same manner as in Example 2, except that the buffer layer was deposited at a deposition rate of 0.2 nm/s to a thickness of 7 nm.

### Comparative Example 1

An organic EL device was manufactured in the same manner as in Example 1, except that the buffer layer was deposited at a deposition rate of 0.05 nm/s to a thickness of 15 nm.

### Comparative Example 2

An organic EL device was manufactured in the same manner as in Example 2, except that the buffer layer was deposited at a deposition rate of 0.05 nm/s to a thickness of 15 nm.

### Comparative Example 3

An organic EL device was manufactured in the same manner as in Example 1, except that the buffer layer was deposited at a deposition rate of 0.05 nm/s to a thickness of 30 nm.

### Comparative Example 4

An organic EL device was manufactured in the same manner as in Example 2, except that the buffer layer was deposited at a deposition rate of 0.3 nm/s to a thickness of 30 nm.

### Experimental Example 1

Driving voltages, efficiencies (current densities), and half-lifes of organic EL devices manufactured according to Examples 1 through 8 and Comparative Example 1 through 4 were measured in the following method, and the results are shown in Table 1.
Brightness: measured using BMSA(Topcon Co.)
Driving voltages: measured using a 238 HIGH CURRENT SOURCE MEASURE UNIT obtained from Keithley Co.
Current Density : 9 or greater points of respective devices were measured while the direct current (DC) was increased by 10mA/cm² in the range of 10 to 100 mA/cm².
Half-life: Times taken when the initial luminance of respective organic EL devices was decreased by its 50% at DC 50mA/cm² were measured. Reproducibility was measured using at least three same devices.

**Table 1**

| | Deposition Rate (nm/s) | Thickness of Buffer Layer (mn) | Driving Voltage (V) | Efficiency (cd/v) | Half-life (h) |
|---|---|---|---|---|---|
| Example 1 | 0.01 | 3 | 6.3 | 14 | 1500 |
| Example 2 | 0.05 | 3 | 6.2 | 13 | 1500 |
| Example 3 | 0.1 | 3 | 6.1 | 13 | 1000 |
| Example 4 | 0.2 | 3 | 6.0 | 12 | 1000 |
| Example 5 | 0.01 | 7 | 9.2 | 17 | 1100 |
| Example 6 | 0.05 | 7 | 8.4 | 16 | 1000 |
| Example 7 | 0.1 | 7 | 6.1 | 14 | 1500 |
| Example 8 | 0.2 | 7 | 6.0 | 14 | 1500 |
| Comparative Example 1 | 0.05 | 15 | 9.4 | 14 | 900 |
| Comparative Example 2 | 0.05 | 25 | 10.2 | 16 | 900 |
| Comparative Example 3 | 0.05 | 30 | 11.0 | 15 | 900 |
| Comparative Example 4 | 0.3 | 30 | 10.9 | 15 | 900 |

Referring to Table 1, organic EL devices according to Examples 1 through 8 had less driving voltages, better luminous efficiency, and longer lifetime than organic EL devices according to Comparative Examples 1 through 4.

### Example 9

A glass substrate with an ITO electrode (obtained from Corning Co., surface resistance 15Ω /cm², thickness 120 nm) cut to a size 50 mm x 50 mm x0.7 mm was cleaned using ultrasonic waves in isopropyl alcohol for 5 minutes, cleaned using ultrasonic waves in pure water for 5 minutes, and cleaned using UV and ozone for 30 minutes, and the result was used as an anode. The resultant glass substrate with ITO electrode was subjected to a plasma treatment at a pressure of 0.1 mtorr or less for 9 minutes.

Buckminster fullerene was vacuum-thermal deposited on the plasma-treated substrate to form a buffer layer with a thickness of 1 nm. Then, IDE406 (obtained from ldemitz Co.) was vacuum-thermal deposited on the buffer layer to form a hole injection layer with a thickness of 70 nm. Subsequently, NPD was vacuum-thermal deposited on the hole injection layer to form a hole transport layer with a thickness of 15 nm.

IDE 140 (Idemitz Co.) was vacuum thermal deposited on the hole transport layer to form a blue emission layer with a thickness of about 30 nm. Subsequently, Alg3 that is an electron transporting material was deposited on the emission layer to form an electron transport layer with a thickness of 25 nm.

LiF was vacuum-deposited on the electron transport layer to a thickness of 1 nm to form an electron injection layer and Al was deposited on the electron injection layer to a thickness of 80 nm to form a cathode, thereby forming a LiF/Al electrode. As a result, an organic EL device was manufactured.

### Examples 10 through 14

Organic EL devices were manufactured in the same manner as in Example 9, except that the buffer layer had a thickness of 2, 3.5, 5, 6.5, or 8 nm, respectively.

### Example 15

A glass substrate with an ITO electrode (obtained from Corning Co., surface resistance 15Ω /cm², thickness 120 nm) was cut to a size 50 mm x 50 mm x 0.7 mm was cleaned using ultrasonic waves in isopropyl alcohol for 5 minutes, cleaned using ultrasonic waves in pure water for 5 minutes, and cleaned using UV and ozone for 30 minutes, and the result was used as an anode. The resultant ITO glass substrate was subjected to a plasma treatment at a pressure of 0.1 mtorr and less for 9 minutes.

Buckminster fullerene was vacuum-thermal deposited on the plasma-treated substrate to form a buffer layer with a thickness of 5 nm. Then, IDE406 (obtained from Idemitz Co.) was vacuum-thermal deposited on the buffer layer to form a hole injection layer with a thickness of 70 nm. Subsequently, NPD was vacuum-thermal deposited on the hole injection layer to form a hole transport layer with a thickness of 15 nm.

C545T and Alq3 were co-deposited on the hole transport layer to form a green emission layer with a thickness of about 35 nm, and then Alq3 as an electron transporting material was deposited on the green emission layer to form an electron transport layer with a thickness of 25 nm.

LiF was vacuum-deposited on the electron transport layer to a thickness of 1 nm to form an electron injection layer and Al was deposited on the electron injection layer to a thickness of 100 nm to form a cathode, thereby forming a LiF/Al electrode. As a result, an organic EL device was manufactured.

### Examples 16 and 17

Organic EL devices were manufactured in the same manner as in Example 15, except that the buffer layer had thicknesses of 6.5 and 8 nm, respectively.

### Example 18

A glass substrate with an ITO electrode (obtained from Corning Co., surface resistance 15Ω /cm², thickness 120 nm) was cut to a size 50 mm x 50 mm x 0.7 mm was cleaned using ultrasonic waves in isopropyl alcohol for 5 minutes, cleaned using ultrasonic waves in pure water for 5 minutes, and cleaned using UV and ozone for 30 minutes, and the result was used as an anode. The resultant ITO glass substrate was subjected to a plasma treatment at a pressure of 0.1 mtorr and less for 9 minutes.

Buckminster fullerene was vacuum-thermal deposited on the plasma-treated substrate to form a buffer layer with a thickness of 5 nm. Then, IDE406 (obtained from Idemitz Co.) was vacuum-thermal deposited on the buffer layer to form a hole injection layer with a thickness of 70 nm. Subsequently, NPD was vacuum-thermal deposited on the hole injection layer to form a hole transport layer with a thickness of 15 nm.

DCJTB and Alq3 were co-deposited on the hole transport layer to form a red emission layer with a thickness of about 35 nm, and then Alq3 as an electron transporting material was deposited on the red emission layer to form an electron transport layer with a thickness of 25 nm.

LiF was vacuum-deposited on the electron transport layer to a thickness of 1 nm to form an electron injection layer and Al was deposited on the electron injection layer to a thickness of 100 nm to form a cathode, thereby forming a LiF/Al electrode. As a result, an organic EL device was manufactured.

### Examples 19 and 20

Organic EL devices were manufactured in the same manner as in Example 15, except that the buffer layer had thicknesses of 6.5 and 8 nm, respectively.

### Comparative Example 5

An organic EL device was manufactured in the same manner as in Example 9, except that the buffer layer was not formed.

### Comparative Example 6

An organic EL device was manufactured in the same manner as in Example 15, except that the buffer layer was not formed.

### Comparative Example 7

An organic EL device was manufactured in the same manner as in Example 18, except that the buffer layer was not formed.

Driving voltages, efficiencies, and half-lifes of the organic EL devices according to Examples 9 through 14 and Comparative Example 5 were measured. The results are shown in Table 2 below.

### 1) Initial characteristics

Luminance was measured using a BMSA (obtained from Topcon Co.), and a driving voltage was measured using a 238 HIGH CURRENT SOURCE MEASURE UNIT (obtained from Keithley). A direct current (DC) density applied to the devices was in the range of 10 to 100 mA/cm², and increased by 10mA/cm². At least 9 points in each device were tested. The reproducibility test was performed more than 9 times, and the deviation of the initial characteristics was 5 % or less.

### 2) Half-life

Half-life was obtained by measuring time that is taken for 50 % loss of the initial luminance at DC 50mA/cm². Reproducibility of the lifetimes of at least three devices having the same structure were measured.

**Table 2**

| | Comparative Example 5 | Example 9 | Example 10 | Example 11 | Example 12 | Example 13 | Example 14 |
|---|---|---|---|---|---|---|---|
| Thickness of buffer layer (nm) | 0 | 10 | 20 | 35 | 50 | 65 | 80 |
| Driving voltage (V) | 9.06 | 7.76 | 7.39 | 7.22 | 7.13 | 6.99 | 6.9 |
| Efficiency (cd/A) | 10.48 | 9.64 | 9.48 | 9.56 | 9.93 | 9.56 | 9.61 |
| Half-life (h) | 600 | 800 | 750 | 750 | 850 | 940 | 800 |

Referring to Table. 2, although the efficiencies of the organic EL devices according to Examples 9 through 14 were almost equal to the efficiency of the organic EL device according to Comparative Example 5, the driving voltages of the organic EL devices according to Examples 9 through 14 were about 80% of the driving voltage of the organic EL device according to Comparative Example 5, and the lifetimes of the organic EL devices according to Examples 9 through 14 were 50% longer than the lifetime of the organic EL device according to Comparative Example 6.

The driving voltages, efficiencies, and half-lifes of the organic EL devices according to Examples 15 through 17 and Comparative Example 6 were measured. The results are shown in Table 3.

**Table 3**

| | Comparative Example 6 | Example 15 | Example 16 | Example 17 |
|---|---|---|---|---|
| Thickness of buffer layer (nm) | 0 | 50 | 65 | 80 |
| Driving voltage (V) | 9.6 | 7.6 | 7.52 | 7.61 |
| Efficiency (cd/A) | 23.66 | 21.59 | 21.95 | 22.06 |
| Half-life (h) | 650 | 750 | 820 | 720 |

Referring to Table. 3, although the efficiencies of the organic EL devices according to Examples 15 through 17 were almost equal to the efficiency of the organic EL device according to Comparative Example 6, the driving voltages of the organic EL devices according to Examples 15 through 17 were about 80% of the driving voltage of the organic EL device according to Comparative Example 6,and the lifetimes of the organic EL devices according to Examples 15 through 17 were 25% of the lifetime of the organic EL device according to Comparative Example 6.

The driving voltages, efficiencies, and half-lifes of the organic EL devices according to Examples 18 through 20 and Comparative Example 7 were measured. The results are shown in Table 4.

**Table 4**

| | Comparative Example 7 | Example 18 | Example 19 | Example 20 |
|---|---|---|---|---|
| Thickness of buffer layer (nm) | 0 | 50 | 65 | 80 |
| Driving voltage (V) | 7.61 | 5.78 | 5.72 | 5.77 |
| Efficiency (cd/A) | 5.62 | 5.16 | 5.65 | 4.98 |
| Half-life (h) | 1500 | 1800 | 1800 | 1500 |

Referring to Table. 4, although the efficiencies of the organic EL devices according to Examples 18 through 20 were almost equal to the efficiency of the organic EL device according to Comparative Example 7, the driving voltages of the organic EL devices according to Examples 18 through 20 were about 80% of the driving voltage of the organic EL device according to Comparative Example 7,and the lifetimes of the organic EL devices according to Examples 18 through 20 were 20% longer than the lifetime of the organic EL device according to Comparative Example 7.

An organic EL device according to an embodiment of the present invention include a buffer layer formed of a carbon-based compound, such as fullerene, interposed between a first electrode and an emission layer in order to obtain a greater driving voltage and a longer lifetime. In addition, the efficiency and lifetime of the organic EL device can be more improved by controlling the thickness of the buffer layer using the deposition rate of the buffer layer.

In particular, the organic EL device according to an embodiment of the present invention includes: i) a buffer layer formed of a carbon-based compound, such as fullerene and the like, interposed between a first electrode and a hole injection layer, between the hole injection layer and a hole transport layer, and/or between the first electrode layer and the hole transport layer; ii) a buffer layer interposed between the first electrode and the hole injection layer, between the first electrode and the hole transport layer, and /or between the hole injection layer and the hole transport layer, wherein the hole injection layer and/or the hole transport layer are doped with the carbon-based compound; iii) an electron transport layer doped with the carbon-based compound; or iv) a buffer layer interposed between the first electrode and the hole injection layer, between the first electrode and the hole transport layer, and/or between the hole injection layer and the hole transport layer, wherein an electron transport layer is doped with the carbon-based compound, in order to increase the driving voltage and lifetime while the color coordinate of blue, green, and red does not change.

## Claims

1. An organic electroluminescent device comprising
an emission layer (12) interposed between a first electrode (10) and a second electrode (13);
a buffer layer (14) which is formed of a carbon-based compound between the emission layer (12) and the first electrode (10), wherein the carbon-based compound is a fullerene,
**characterized in that**
the organic electroluminescent device further comprises
(i) a hole injection layer (11) between the first electrode (10) and the emission layer (12), wherein the buffer layer (14) is formed between the first electrode (10) and the hole injection layer (11); and/or
(ii) a hole transport layer (16) between the first electrode (10) and the emission layer (12), wherein the buffer layer (14) is formed between the first electrode (10) and the hole transport layer (16).

2. The organic electroluminescent device of claim 1, wherein the thickness of the buffer layer (14) is in the range of 0.1 to 100nm.

3. A method of manufacturing an organic electroluminescent device comprising an emission layer (12) interposed between a first electrode (10) and a second electrode (13),
a buffer layer (14) which is formed of a carbon-based compound between the emission layer (12) and the first electrode (10), wherein the carbon-based compound is a fullerene; and
(i) a hole injection layer (11) between the first electrode (10) and the emission layer (12), wherein the buffer layer (14) is formed between the first electrode (10) and the hole injection layer (11); and/or
(ii) a hole transport layer (16) between the first electrode (10) and the emission layer (12), wherein the buffer layer (14) is formed between the first electrode (10) and the hole transport layer (16);
the method comprising forming the buffer layer (14) to a thickness of 0.1 nm to 100 nm between the emission layer (12) and the first electrode (10).

4. The method of claim 3, wherein the buffer layer (14) is deposited at the deposition rate of 0.01 nm/s to 0.2 nm/s.

5. The method of claim 4, wherein the buffer layer (14) is deposited at the deposition rate of 0.01 nm/s to 0.05 nm/s to a thickness of 1 nm to 5 nm or wherein the buffer layer is deposited at the deposition rate of 0.05 nm/s to 0.2 nm/s to a thickness of 5 nm to 10 nm.

## Patentansprüche

1. Organische elektrolumineszente Vorrichtung, aufweisend:
eine Emissionsschicht (12), welche zwischen einer ersten Elektrode (10) und einer zweiten Elektrode (13) angeordnet ist;
eine Pufferschicht (14), welche aus einer auf der Basis von Kohlenstoff hergestellten Verbindung gebildet ist und zwischen der Emissionsschicht (12) und der ersten Elektrode (10) ausgebildet ist, wobei die auf der Basis von Kohlenstoff hergestellte Verbindung ein Fulleren ist,
**dadurch gekennzeichnet, dass**
die organische elektrolumineszente Vorrichtung weiterhin aufweist
(i) eine zwischen der ersten Elektrode (10) und der Emissionsschicht (12) befindliche Lochinjektionsschicht (11), wobei die Pufferschicht (14) zwischen der ersten Elektrode (10) und der Lochinjektionsschicht (11) ausgebildet ist; und/oder
(ii) eine zwischen der ersten Elektrode (10) und der Emissionsschicht (12) befindliche Lochtransportschicht (16), wobei die Pufferschicht (14) zwischen der ersten Elektrode (10) und der Lochtransportschicht (16) ausgebildet ist.

2. Organische elektrolumineszente Vorrichtung nach Anspruch 1, wobei die Dicke der Pufferschicht (14) im Bereich von 0,1 bis 100 nm liegt.

3. Verfahren zur Herstellung einer organischen elektrolumineszenten Vorrichtung, wobei die organische elektrolumineszente Vorrichtung aufweist:
eine Emissionsschicht (12), welche zwischen einer ersten Elektrode (10) und einer zweiten Elektrode (13) angeordnet ist,
eine Pufferschicht (14), welche aus einer auf der Basis von Kohlenstoff hergestellten Verbindung gebildet ist und zwischen der Emissionsschicht (12) und der ersten Elektrode (10) ausgebildet ist, wobei die auf der Basis von Kohlenstoff hergestellte Verbindung ein Fulleren ist; und
(i) eine zwischen der ersten Elektrode (10) und der Emissionsschicht (12) befindliche Lochinjektionsschicht (11), wobei die Pufferschicht (14) zwischen der ersten Elektrode (10) und der Lochinjektionsschicht (11) ausgebildet ist; und/oder
(ii) eine zwischen der ersten Elektrode (10) und der Emissionsschicht (12) befindliche Lochtransportschicht (16), wobei die Pufferschicht (14) zwischen der ersten Elektrode (10) und der Lochtransportschicht (16) ausgebildet ist;
wobei das Verfahren die Ausbildung der Pufferschicht (14), welche zwischen der Emissionsschicht (12) und der ersten Elektrode (10) ausgebildet wird, mit einer Dicke von 0,1 nm bis 100 nm aufweist.

4. Verfahren nach Anspruch 3, wobei die Pufferschicht (14) mit einer Abscheiderate von 0,01 nm/s bis 0,2 nm/s abgeschieden wird.

5. Verfahren nach Anspruch 4, wobei die Pufferschicht (14) bei einer Abscheiderate von 0,01 nm/s bis 0,05nm/s mit einer Dicke von 1 nm bis 5 nm abgeschieden wird, oder wobei die Pufferschicht bei einer Abscheiderate von 0,05 nm/s bis 0,2 nm/s mit einer Dicke von 5 nm bis 10 nm abgeschieden wird.

## Revendications

1. Dispositif électroluminescent organique comportant :
une couche d'émission (12) interposée entre une première électrode (10) et une seconde électrode (13) ;
une couche tampon (14) qui est formée d'un composé à base de carbone entre la couche d'émission (12) et la première électrode (10), dans laquelle le composé à base de carbone est un fullerène,
**caractérisé en ce que**
le dispositif électroluminescent organique comporte en outre
(i) une couche (11) d'injection de trou entre la première électrode (10) et la couche d'émission (12), la couche tampon (14) étant formée entre la première électrode (10) et la couche (11) d'injection de trou ; et/ou
(ii) une couche (16) de transport de trou entre la première électrode (10) et la couche d'émission (12), la couche tampon (14) étant formée entre la première électrode (10) et la couche (16) de transport de trou.

2. Dispositif électroluminescent organique selon la revendication 1, dans lequel l'épaisseur de la couche tampon (14) est dans la plage de 0,1 à 100 nm.

3. Procédé de fabrication d'un dispositif électroluminescent organique comportant une couche d'émission (12) interposée entre une première électrode (10) et une seconde électrode (13),
une couche tampon (14) qui est formée d'un composé à base de carbone entre la couche d'émission (12) et la première électrode (10), le composé à base de carbone étant un fullerène ; et
(i) une couche (11) d'injection de trou entre la première électrode (10) et la couche d'émission (12), la couche tampon (14) étant formée entre la première électrode (10) et la couche (11) d'injection de trou ; et/ou
(ii) une couche (16) de transport de trou entre la première électrode (10) et la couche d' émission (12), la couche tampon (14) étant formée entre la première électrode (10) et la couche (16) de transport de trou ;
le procédé comprenant la formation de la couche tampon (14) à une épaisseur de 0,1 nm à 100 nm entre la couche d'émission (12) et la première électrode (10).

4. Procédé selon la revendication 3, dans lequel la couche tampon (14) est déposée à la vitesse de dépôt de 0,01 nm/s à 0,2 nm/s.

5. Procédé selon la revendication 4, dans lequel la couche tampon (14) est déposée à la vitesse de dépôt de 0,01 nm/s à 0,05 nm/s à une épaisseur de 1 nm à 5 nm, ou dans lequel la couche tampon est déposée à la vitesse de dépôt de 0,05 nm/s à 0,2 nm/s à une épaisseur de 5 nm à 10 nm.
